# EUROPÄISCHE PATENTSCHRIFT

(11) **EP 3 026 702 B1**
(45) Veröffentlichungstag und Bekanntmachung des Hinweises auf die Patenterteilung: **22.07.2020**
(21) Anmeldenummer: 15185314.0
(22) Anmeldetag: 15.09.2015
(51) Int. Cl.: H01L 23/492, H01L 21/683, H01L 23/00, H01L 23/49

(54) **VERFAHREN ZUM HERSTELLEN EINES HALBLEITERELEMENTS MIT SUBSTRATADAPTER UND HALBLEITERELEMENT MIT SUBSTRATADAPTER**
METHOD OF PRODUCING A SEMICONDUCTOR ELEMENT WITH SUBSTRATE ADAPTER AND SEMICONDUCTOR ELEMENT WITH SUBSTRATE ADAPTER
PROCEDE DE FABRICATION D'UN ELEMENT SEMI-CONDUCTEUR DOTE D'UN ADAPTATEUR DE SUBSTRAT ET ELEMENT SEMI-CONDUCTEUR DOTE D'UN ADAPTATEUR DE SUBSTRAT

(30) Priorität: 25.11.2014 DE 102014117245
(43) Veröffentlichungstag der Anmeldung: 01.06.2016
(73) Patentinhaber: Heraeus Deutschland GmbH & Co. KG, 63450 Hanau (DE)
(72) Erfinder: Bleifuß, Martin, 63796 Kahl (DE); Hinrich, Andreas, 63579 Freigericht (DE); Klein, Andreas, 63579 Freigericht (DE); Schäfer, Michael, 36093 Künzell (DE); Wieseler, Elisa, 63768 Hösbach (DE); Bachmann, Christian, 6430 Nordborg (DK); Holger, Ulrich, 6430 Nordborg (DK); Osterwald, Frank, 6430 Nordborg (DK); Benning, David, 6430 Nordborg (DK); Rudzki, Jacek, 6430 Nordborg (DK); Paulsen, Lars, 6430 Nordborg (DK); Schefuss, Frank, 6430 Nordborg (DK); Becker, Martin, 6430 Nordborg (DK)
(74) Vertreter: Kilchert, Jochen

(56) Entgegenhaltungen:
- EP-A2- 1 772 900
- WO-A1-2013/053419
- JP-A- H11 204 551
- US-A1- 2005 247 760
- US-A1- 2008 160 183
- US-A1- 2012 114 927
- US-A1- 2014 284 624

## Beschreibung

Die Erfindung betrifft ein Verfahren zum Herstellen eines Halbleiterelements mit einem Substratadapter.

Steigende Anforderungen in Leistungselektronik-Modulen, die beispielsweise die Leitfähigkeiten und die Lebensdauern betreffen, erfordern den Einsatz von Cu-Bond-Drähten zur Kontaktierung von Leistungshalbleitern untereinander oder anderen Anschlüssen innerhalb eines Leistungselektronik-Moduls. Als Chip-Metallisierung wird derzeit überwiegend eine Aluminium-Beschichtung bzw. Aluminium-Metallisierung verwendet, wobei dies zu Problemen im Kontaktierungsprozess und in der späteren Anwendung führt.

Beispielsweise kann es aufgrund einer derartigen Metallisierung zu späteren Ausfällen der Leistungselektronik-Module im Betrieb kommen.

Es existieren verschiedene Lösungsansätze zur Steigerung der Systemlebensdauer, so z.B. die Verwendung von sogenannten Flex-Leiterplatten. Allerdings sind auch derartige Flex-Leiterplatten mit einem Nachteil verbunden, da diese nicht mit einem konventionellen Draht-Bond-Prozess kontaktiert werden können, so dass bestehende Produktionskapazitäten nicht mehr genutzt werden können.

Derzeit bekannte Verfahren zum Kontaktieren von Halbleiterelementen sehen vor, dass zunächst ein Metallelement mit Kontaktierungsmaterial versehen wird, um dieses beim Endkunden bzw. in einem nachgelagerten Verfahrensschritt mit einem Halbleiterelement zu verbinden. Ein derartiges Verfahren ist allerdings sehr kostenintensiv.

Ein weiteres Verfahren zum Kontaktieren von Halbleiterelementen ist aus der EP 1 772 900 A2 bekannt.

Die Aufgabe der vorliegenden Erfindung ist es, eine, insbesondere hinsichtlich der Zuverlässigkeit der hergestellten Halbleitereinrichtung, insbesondere Leistungshalbleiter-Einrichtungen, verbesserte Lösung bereitzustellen. Außerdem soll ein Verfahren angegeben werden, das kosteneffizienter durchgeführt werden kann.

Erfindungsgemäß wird diese Aufgabe im Hinblick auf ein Verfahren zum Herstellen mindestens eines Halbleiterelements mit einem Substratadapter durch ein Verfahren mit den Merkmalen des Patentanspruches 1 gelöst.

Vorteilhafte und zweckmäßige Ausgestaltungen des erfindungsgemäßen Verfahrens zum Herstellen eines Halbleiterelements mit Substratadapter sind in den Unteransprüchen angegeben.

Das erfindungsgemäße Verfahren zum Herstellen mindestens eines Halbleiterelements mit einem Substratadapter umfasst unter anderem die Schritte:
- Strukturieren eines elektrisch leitenden Metallelements,
- Aufbringen eines Kontaktierungsmaterials auf eine erste Seite eines Halbleiterelements, wobei das Halbleiterelement mit einer zweiten Seite auf einem Transportelement angeordnet ist,
- Positionieren des strukturierten Metallelements und des Halbleiterelements derart, dass eine erste Seite des strukturierten Metallelements und die mit dem Kontaktierungsmaterial versehene erste Seite des Halbleiterelements gegenüber angeordnet sind, und
- Fügen des strukturierten Metallelements mit dem mit Kontaktierungsmaterial versehenen Halbleiterelement.

Bei dem elektrisch leitenden Metallelement kann es sich beispielsweise um eine Kupferfolie handeln. Das elektrisch leitende Metallelement kann aus reinem Kupfer oder aus einer Kupferlegierung bestehen. Diesbezüglich ist es denkbar, dass das Metallelement aus CuNi, CuSn, CuFe, CuNiSz, CuAg, CuW oder CuMo besteht. Des Weiteren ist es denkbar, dass das Metallelement aus reinem Silber besteht.

Das Strukturieren eines elektrisch leitenden Metallelements betrifft das Einarbeiten von Strukturen in ein elektrisch leitendes Metallelement, wobei die Strukturen sowohl auf einer als auch auf mehreren Seiten eines elektrisch leitenden Metallelements eingearbeitet werden können. Vorzugsweise erfolgt das Strukturieren eines elektrisch leitenden Metallelements im Hinblick auf die zu erlangende Form eines Halbleiterelements bzw. die zu erlangende Form eines Halbleiterelements mit Substratadapter. Beispielsweise ist es möglich, dass in ein elektrisch leitendes Metallelement im Abstand zueinander gleichartige bzw. übereinstimmende Formen eingearbeitet werden.

Bei dem auf die erste Seite des Halbleiterelements aufgebrachten Kontaktierungsmaterial kann es sich beispielsweise um ein sinterbares Material bzw. um ein Sintermaterial handeln. Das Kontaktierungsmaterial kann Sinterpaste und/oder eine Sinterfolie sein, wobei das Sintermaterial und/oder die Sinterpaste und/oder die Sinterfolie beispielsweise Silber und/oder eine Silberverbindung enthalten kann.

In einer weiteren Ausführungsform der Erfindung kann das Kontaktierungsmaterial ein Lot und/oder ein Leitkleber sein.

Das Aufbringen eines Kontaktierungsmaterials auf die erste Seite des Halbleiterelements kann beispielsweise durch Sprayen, Jetten, Siebdrucken, Schablonendrucken oder durch indirektes Drucken erfolgen.

Bei dem mit einem Kontaktierungsmaterial versehenen Halbleiterelement und dem strukturierten elektrisch leitenden Metallelement handelt es sich hiernach zunächst um zwei voneinander getrennt zu bearbeitende Elemente, die anschließend zueinander positioniert werden. Die Positionierung des strukturierten Metallelements zu dem Halbleiterelement erfolgt derart, dass die erste Seite des Metallelements und die mit dem Kontaktierungsmaterial versehene erste Seite des Halbleiterelements gegenüberliegend angeordnet sind. Die erste Seite des Metallelements und die mit dem Kontaktierungsmaterial versehene Seite des Halbleiterelements weisen zueinander.

Nach der vorzugsweise passgenauen Positionierung des strukturierten Metallelements in Relation zu dem Halbleiterelement erfolgt ein Fügen des strukturierten Metallelements mit dem mit Kontaktierungsmaterial versehenen Halbleiterelement.

Das Besondere an dem erfindungsgemäßen Verfahren ist, dass ein Substratadapter direkt auf einem Halbleiterelement aufgebaut wird. Es entfallen somit weitere Füge-Schritte. Das Halbleiterelement wird demnach bereits in einem sehr frühen Stadium der Prozesskette mit einem Substratadapter versehen, um den Aufwand der nachträglichen Bestückung zu reduzieren. Der Substratadapter wird zu einem frühen Zeitpunkt und in großer Stückzahl auf einem Halbleiterelement aufgebracht. Hierbei handelt es sich um ein kosteneffizientes Verfahren im Vergleich zu Verfahren, die nachgelagerte, einzelne Bestückungsprozesse vorsehen.

Erfindungsgemäß wird das mit dem Halbleiterelement und dem Kontaktierungsmaterial zusammengefügte strukturierte Metallelement zur weiteren Verarbeitung vereinzelt derart, dass das Transportelement die durch die vereinzelten Metallelemente und dem Kontaktierungsmaterial gebildeten Substratadapter in einem Abstand zueinander fixiert sind. Die einzelnen Substratadapter sind aufgrund des nichtvereinzelten Transportelements in Lage zueinander gehalten. Die Substratadapter sind demnach auf dem Transportelement nebeneinander in einem definierten Abstand zueinander angeordnet. Der Abstand zwischen den einzelnen Substratadaptern bleibt beispielsweise während eines Transportvorgangs erhalten.

Das Transportelement kann ein Film-Frame sein.

Erfindungsgemäß wird das Halbleiterelement mit dem aufgebrachten Kontaktierungsmaterial und dem zusammengefügten Metallelement vom Transportelement entfernt und auf einen mit einem weiteren Kontaktierungsmaterial versehenen Träger aufgebracht, wobei die zweite Seite des Halbleiterelements mit dem mit einem weiteren Kontaktierungsmaterial versehenen Träger in Kontakt gebracht wird. Anschließend wird die Anordnung eines Halbleiterelements mit Kontaktierungsmaterial und Metallelement vollständig vom Transportelement abgehoben und auf einen Träger, der mit weiterem Kontaktierungsmaterial versehen ist, aufgesetzt. Diese Anordnung auf dem Träger wird zusammengefügt.

Erfindungsgemäß wird mindestens ein vereinzeltes Halbleiterelement mit mindestens einem Substratadapter vom Transportelement entfernt und auf einen mit einem weiteren Kontaktierungsmaterial versehenen Träger aufgebracht, wobei die zweite Seite des mindestens einen vereinzelten Halbleiterelements mit dem mit einem weiteren Kontaktierungsmaterial versehenen Träger in Kontakt gebracht werden. Erfindungsgemäß ist es demnach möglich, vereinzelte Substratadapter-Halbleiterelement-Anordnungen vom Transportelement abzulösen, um diese Anordnung auf einem mit einem weiteren Kontaktierungsmaterial versehenen Träger aufzusetzen. Erfindungsgemäß ist das Fügen der Anordnung mit dem Träger vorgesehen.

Optional kann es vorgesehen sein, dass die erste Seite des strukturierten Metallelements mit einem ersten Beschichtungssystem und/oder die zweite Seite des strukturierten Metallelements mit einem zweiten Beschichtungssystem beschichtet wird, wobei das Beschichten der ersten und/oder der zweiten Seite des strukturierten Metallelements vorzugsweise vor dem Positionieren des strukturierten Metallelements in Relation zu dem Halbleiterelement erfolgt. Das optionale Beschichten der ersten und/oder der zweiten Seite des Metallelements kann beispielsweise mittels Galvanisierung durchgeführt werden. Das erste Beschichtungssystem und das zweite Beschichtungssystem sind vorzugsweise unterschiedliche Metalle, insbesondere Nickel, Silber und/oder Gold.

Es kann des Weiteren vorgesehen sein, dass auf die zweite Seite des strukturierten Metallelements, vorzugsweise vor dem Vereinzeln des mit dem Halbleiterelement und dem Kontaktierungsmaterial zusammengefügten strukturierten Metallelements eine Schutzfolie aufgebracht wird. Eine derartige Schutzfolie schützt die zweite Seite des strukturierten Metallelements vor Beschädigung und/oder Verunreinigung und/oder ungewollter elektrischer Kontaktierung.

Erfindungsgemäß sind das Transportelement und der Träger eine Folie, deren Adhäsion zu einem verbundenen Kontaktierungsmaterial oder Metallelement oder Halbleiterelement geringer ist als die Adhäsion einer Verbindung zwischen einem Kontaktierungsmaterial und/oder einem Metallelement und/oder einem Halbleiterelement. Mit anderen Worten ist die Adhäsion der Folie geringer als die Adhäsion aller anderen Elemente bzw. Materialien der gefügten Anordnung zueinander.

Erfindungsgemäß ist die Adhäsion zwischen dem Transportelement und dem mindestens einen Halbleiterelement und zwischen dem Träger und dem weiteren Kontaktierungsmaterial geringer ist als die Adhäsion zwischen dem mindestens einen Halbleiterelement und dem Kontaktierungsmaterial derart, dass das weitere Kontaktierungsmaterial bei einem Ablösen des mindestens einen Halbleiterelements von dem Träger am Halbleiterelement haftet. In diesem Zusammenhang ist es denkbar, die Folie, die als Transportelement und/oder Träger verwendet wird, vor dem gewünschten Ablösen mit UV-Licht zu bestrahlen, so dass die Klebekraft bzw. Adhäsion der Folie zum verbundenen Kontaktierungsmaterial oder Metallelement oder Halbleiterelement verringert wird.

Das Aufbringen des Kontaktierungsmaterials auf die erste Seite des Halbleiterelements und/oder das Aufbringen des weiteren Kontaktierungsmaterials auf eine Seite des Trägers kann mit einer vorbestimmten Struktur ausgeführt werden, die passgenau zur Struktur des strukturierten Metallelements und/oder zur Struktur des Halbleiterelements, ist. In einer weiteren Ausführungsform der Erfindung kann es vorgesehen sein, dass das auf das Halbleiterelement aufgebrachte Kontaktierungsmaterial und/oder das auf den Träger aufgebrachte weitere Kontaktierungsmaterial vorgetrocknet wird, bevor das strukturierte Metallelement mit dem Halbleiterelement bzw. der Träger mit einem Halbleiterelement zusammengefügt wird.

Während des Fügens des Metallelements mit dem Halbleiterelement kann auf die zweite Seite des Metallelements ein Stempel wirken, insbesondere bei einer Temperatur von 60 °C bis 130 °C, insbesondere von 80 °C bis 110 °C, insbesondere von 80 °C bis 100 °C. Es ist möglich, dass beim Zusammenfügen der Stempel beheizt ist. In einer alternativen Ausführungsform der Erfindung ist es denkbar, das Aufbringen einer erhöhten Temperatur in den angegebenen Wertebereichen auf die gesamte zusammenzufügende Anordnung erfolgt.

Während des Fügens kann auf die zweite Seite des Halbleiterelements und/oder auf das Transportmittel und/oder auf den Träger ein Gegenhalter und/oder ein Gegenstempel wirken. Beim Fügen des Metallelements mit dem Halbleiterelement wird auf die zweite Seite des Metallelements beispielsweise eine Kraft von weniger als 5 MPa, insbesondere weniger als 2 MPa, insbesondere weniger als 1 MPa, aufgebracht.

Im Rahmen des erfindungsgemäßen Verfahrens ist es möglich, dass das mit dem Halbleiterelement zusammengefügte, strukturierte und optional mit einer/der Schutzfolie versehene Metallelement, vorzugsweise durch Sägen oder Laserschneiden oder Stanzen oder Ätzen oder Wasserstrahlschneiden, vereinzelt wird. Aufgrund des Vereinzelns wird auf einem Träger und/oder einem Transportmittel eine Anordnung mehrerer Halbleiterelemente mit mehreren Substratadaptern hergestellt.

Ein Halbleiterelement mit Substratadapter kann mit dem erfindungsgemäßen Verfahren hergestellt werden. Der Substratadapter umfasst mindestens einen Metallelementabschnitt und mindestens einen Kontaktierungsmaterialabschnitt. Des Weiteren ist es möglich, dass der Substratadapter auch mindestens einen Schutzfolienabschnitt umfasst.

Optional können diese Abschnitte zusammen mit dem jeweiligen Halbleiterelement auf einem Träger und/oder auf einem Transportmittel befindlich sein. Das erfindungsgemäße Verfahren umfasst weiterhin den Schritt:
- Ablösen des Halbleiterelements und des Substratadapters, der das Metallelement mit zusammengefügtem Kontaktierungsmaterial umfasst, vom Träger.

Weiterhin kann ein Verfahren zum Kontaktieren eines Halbleiterelements mit Substratadapter folgende Schritte umfassen:
- Positionieren des Halbleiterelements mit Substratadapter und einem Trägersubstrat für elektronische Bauteile zueinander, derart, dass die zweite, optional mit einem weiteren Kontaktierungsmaterial versehene Seite des Halbleiterelements und das Trägersubstrat für elektronische Bauteile gegenüberliegen,
- Anheften des Halbleiterelements mit dem Substratadapter auf dem Trägersubstrat für elektronische Bauteile durch Wärme- und/oder Druckbeaufschlagung, und
- Kontaktieren der zweiten Seite des Metallelements mit einem Kontaktierungselement, insbesondere einem Bonddraht oder einem Bond-Bändchen oder einem Clip.

Bei dem Trägersubstrat für elektronische Bauteile kann es sich beispielsweise um eine Platine oder ein DCB-Substrat oder ein PCB-Substrat oder ein Leadframe oder eine keramische Leiterplatte handeln.

Mit dem erfindungsgemäßen Verfahren wird des Weiteren vorgeschlagen, dass das Kontaktierungselement, insbesondere der Bonddraht oder das Bond-Bändchen oder der Clip aus reinem Kupfer oder einer Kupferlegierung besteht.

Diesbezüglich ist es denkbar, dass das Metallelement aus CuNi, CuSn, CuFe, CuNiSz, CuAg, CuW oder CuMo besteht. Des Weiteren ist es denkbar, dass das Kontaktierungselement aus reinem Silber besteht.

Mit einer Weiterbildung wird vorgeschlagen, vor dem Kontaktieren der zweiten Seite des Metallelements mit einem Kontaktierungselement eine Schutzfolie von der zweiten Seite des Metallelements zu entfernen, so dass die zweite Seite freigelegt wird.

Es kann des Weiteren vorgesehen sein, dass das Halbleiterelement mit dem Trägersubstrat für elektronische Bauteile versintert und/oder verlötet und/oder verklebt wird. Bei dem Trägersubstrat für elektronische Bauteile kann es sich beispielsweise um eine Platine oder ein BCB-Substrat oder ein PCB-Substrat oder ein Leadframe oder eine keramische Leiterplatte handeln.

Mit Hilfe des erfindungsgemäßen Verfahrens zur Herstellung eines Halbleiterelements mit einem Substratadapter wird ein Halbleiterelement zur Verfügung gestellt, das zusammen mit dem Kontaktierungsmaterial einem Kunden bzw. einer Ver- bzw. Bearbeitungslinie zur Verfügung gestellt werden kann. Das Halbleiterelement bzw. eine Anordnung mit mehreren Halbleiterelementen und darauf befindlichen Substratadaptern kann auf einem Film-Frame bereitgestellt werden. In einer derartigen Lieferform kann es direkt in einem nächsten Prozess- bzw. Verfahrensschritt vom Film-Frame entnommen und auf ein Trägersubstrat für elektronische Bauteile gesintert werden. Dies entspricht der sogenannten Pick-and-Place-Technologie. Das heißt, dass das Halbleiterelement zusammen mit dem Substratadapter mit Hilfe einer Robotik bzw. einer Greifvorrichtung oder einer Ansaugvorrichtung von einem Träger bzw. dem Film-Frame gelöst und zu einem entsprechenden Trägersubstrat für elektronische Bauteile transportiert werden kann. Dadurch werden wirtschaftliche Vorteile wie z.B. ein schnellerer Herstellungsprozess sowie verbesserte Transportmöglichkeiten erzielt.

Außerdem kann mit Hilfe des bereits beschriebenen Pick-and-Place-Verfahrens das mindestens eine Halbleiterelement unabhängig, flexibel und selbst in komplizierter Umgebung eingesetzt werden. Zudem können bereits bei einem weiterverarbeitenden Unternehmen vorhandene Pick-and-Place-Maschinen zum Einsatz kommen.

Im Folgenden werden Ausführungsbeispiele des erfindungsgemäßen Verfahrens anhand von drei schematisch dargestellten Figuren erläutert, ohne jedoch dabei die Erfindung zu beschränken.

Dabei zeigt:
- Fig. 1: eine schematische Querschnittansicht eines Halbleiterelements mit Substratadapter, hergestellt gemäß einer ersten Ausführungsform des erfindungsgemäßen Verfahrens;
- Fig. 2: die schematische Querschnittansicht der Fig. 1 unter Andeutung eines Vereinzelungsschrittes; und
- Fig. 3: eine Querschnittansicht eines Halbleiterelements mit Substratadapter, hergestellt gemäß einer weiteren Ausführungsform des erfindungsgemäßen Verfahrens.

Im Folgenden werden für gleiche und gleich wirkende Teile gleiche Bezugsziffern verwendet.

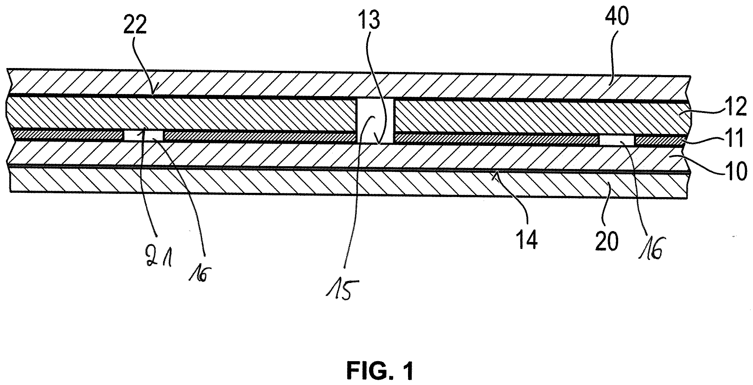

In Fig. 1 zeigt ein elektrisch leitendes Metallelement 12 mit einer ersten Seite 21 und einer zweiten Seite 22. Das elektrisch leitende Metallelement 12 ist strukturiert, d.h. das Metallelement 12 weist im dargestellten Beispiel zwei Abschnitte auf, die durch eine Trennstelle 15 voneinander getrennt sind.

Ebenfalls dargestellt ist ein Halbleiterelement 10, wobei auf eine erste Seite 13 des Halbleiterelements 10 ein Kontaktierungsmaterial 11 aufgebracht ist. Das Halbleiterelement 10 ist mit der zweiten Seite 14 auf einem Transportelement 20 angeordnet. Das dargestellte strukturierte elektrische leitende Metallelement 12 ist vorliegend eine Kupferfolie. Es ist des Weiteren denkbar, dass das Metallelement aus Kupferlegierungen oder Silber hergestellt ist. Bei dem Kontaktierungsmaterial 11 handelt es sich vorliegend um eine Sinterpaste.

Das Kontaktierungsmaterial 11 ist auf die erste Seite 13 des Halbleiterelements 10 beispielsweise durch Siebdrucken oder Schablonendrucken oder Rakeln oder Sprayen oder Jetten oder indirektes Drucken aufgebracht. Das Aufbringen des Kontaktierungsmaterials 11 auf die erste Seite 13 des Halbleiterelements 10 wird mit einer vorbestimmten Struktur ausgeführt, die passgenau zur Struktur des strukturierten Metallelements 12 ist. Im dargestellten Beispiel weist das Kontaktierungsmaterial 11 an der Position, an der das Metallelement 12 eine Trennstelle 15 aufweist, ebenfalls eine Trennstelle 16 auf.

Das strukturierte elektrisch leitende Metallelement 12 und das mit einem Kontaktierungsmaterial 11 versehene Halbleiterelement 10 sind in einem ersten Verfahrensschritt voneinander getrennte Bauteile. Es folgt ein Positionieren des strukturierten Metallelements 12 und des Halbleiterelements 10 derart, dass die erste Seite 21 des strukturierten Metallelements 12 und die mit dem Kontaktierungsmaterial 11 versehene erste Seite 13 des Halbleiterelements 10 gegenüber angeordnet sind. Anschließend wird das strukturierte Metallelement 12 mit dem dem Kontaktierungsmaterial 11 versehenen Halbleiterelement 10 gefügt bzw. zusammengefügt.

Beim Transportelement 20 handelt es sich erfindungsgemäß um eine Folie, deren Adhäsion zum verbundenen Halbleiterelement 10 geringer ist als die Adhäsion der in Fig. 1 darüber aufgebrachten Materialien und Elemente. Das heißt, die Adhäsion zwischen dem Transportelement 20 und dem Halbleiterelement 10 ist geringer als die Adhäsion zwischen dem Halbleiterelement und dem Kontaktierungsmaterial 11 sowie dem Metallelement 20.

Auf die zweite Seite 22 des Metallelements 12 ist eine Schutzfolie 40 aufgebracht. Das Kontaktierungsmaterial 11 ist auf dem Halbleiterelement 10 strukturiert aufgebracht. Das Kontaktierungsmaterial 11 weist Trennstellen auf.

Während des Fügens des Metallelements 12 mit dem Halbleiterelement 10 wirkt auf die zweite Seite 22 des Metallelements 12 und somit auf die Schutzfolie 40 ein Stempel, wobei der Fügeprozess bei einer Temperatur von 60 °C bis 130 °C durchgeführt wird. Während des Fügens wirkt auf das Transportmittel 20 ein Gegenhalter und/oder ein Gegenstempel (nicht dargestellt).

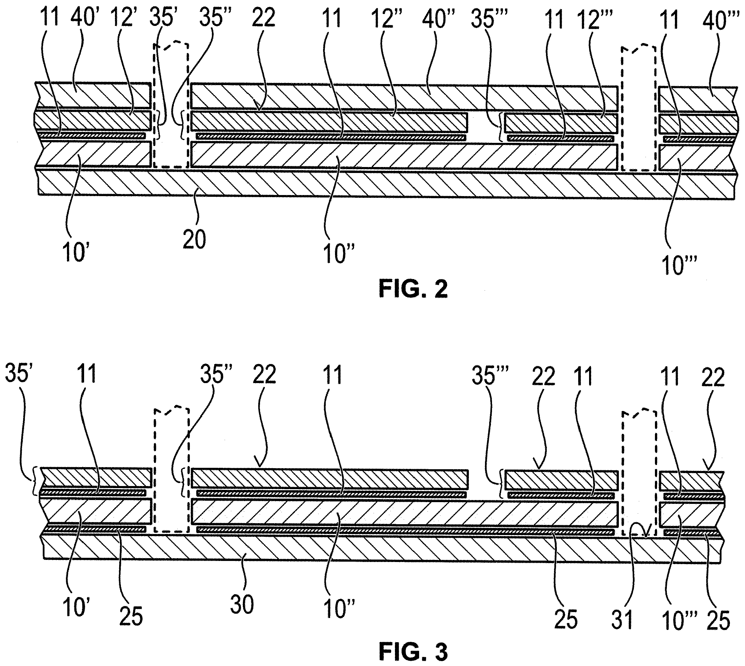

Fig. 2 zeigt einen weiterführenden Verfahrensschritt. An den gestrichelt dargestellten Positionen erfolgt ein Vereinzeln des mit dem Halbleiterelement 10 und dem Kontaktierungsmaterial 11 zusammengefügten strukturierten Metallelements 12 zur weiteren Verarbeitung derart, dass das Transportelement 20 die durch die vereinzelten Metallelemente 12', 12", 12"' und dem Kontaktierungsmaterial 11 gebildeten Substratadapter 35', 35" und 35'" in einem Abstand zueinander fixiert sind. Die Substratadapter 35', 35" und 35'" sind somit in einem definierten Abstand hinsichtlich ihrer Lage zueinander fixiert.

Das Vereinzeln des mit dem Halbleiterelement 10 zusammengefügten, strukturierten und mit einer Schutzfolie 40 versehenen Metallelements 12 kann durch Sägen oder Laserschneiden oder Stanzen oder Ätzen oder Wasserstrahlschneiden erfolgen. Der Abstand der Substratadapter 35', 35" und 35'" zueinander entspricht der Breite der Trennstelle 16 des Kontaktierungsmaterials 11, wie diese in Fig. 1 dargestellt ist.

Beim Fügen des Metallelements 12 mit dem Halbleiterelement 10 wird auf die zweite Seite 22 des Metallelements 12 eine Kraft von weniger als 5 MPa, insbesondere weniger als 2 MPa, insbesondere weniger als 1 MPa, aufgebracht.

Wie in Fig. 3 dargestellt wird, werden die zwei vereinzelten Halbleiterelemente 10' und 10" mit dem auf dem Halbleiterelement 10' befindlichen Substratadapter 35' und dem auf dem Halbleiterelement 10" befindlichen Substratadaptern 35" und 35" vom Transportelement 20 entfernt und auf einen mit einem weiteren Kontaktierungsmaterial 35 versehenen Träger 30 ausgebracht. Die jeweilige zweite Seite 14 der Halbleiterelemente 10' und 10' werden mit dem mit einem weiteren Kontaktierungsmaterial 25 versehenen Träger 30 in Kontakt gebracht. Bei dem weiteren Kontaktierungsmaterial 25 kann es sich ebenfalls um eine silberhaltige Sinterpaste handeln. Das weitere Kontaktierungsmaterial 25 kann auf den Träger durch Sprayen, Jetten, Rakeln, Dispensen, Siebdrucken, Schablonendrucken oder indirektes Drucken aufgebracht werden.

Der Träger 30 ist eine Folie, wobei die Adhäsion zwischen dem Träger 30 und dem weiteren Kontaktierungsmaterial 25 geringer ist als die Adhäsion zwischen dem weiteren Kontaktierungsmaterial 25 und den Halbleiterelementen 10', 10" und 10"'. Somit ist es möglich, dass das weitere Kontaktierungsmaterial 25 bei einem Ablösen der Halbleiterelemente 10', 10" und 10'" von dem Träger 30 am Halbleiterelement 10', 10" und 10'" haften bleibt. Auch das weitere Kontaktierungsmaterial 25 ist in einer bestimmten Struktur auf den Träger 30 aufgebracht.

Die in der voranstehenden Beschreibung sowie in den Ansprüchen, Figuren und Ausführungsbeispielen offenbarten Merkmale der Erfindung können sowohl einzeln als auch in jeder beliebigen Kombination für die Verwirklichung der Erfindung in ihren verschiedenen Ausführungsformen wesentlich sein.

### Bezugszeichenliste

- 10, 10', 10", 10": Halbleiterelement
- 11: Kontaktierungsmaterial
- 12: Metallelement
- 13: erste Seite Halbleiterelement
- 14: zweite Seite Halbleiterelement
- 15: Trennstelle
- 16: Trennstelle
- 20: Transportelement
- 21: erste Seite Metallelement
- 22: zweite Seite Metallelement
- 25: weiteres Kontaktierungsmaterial
- 30: Träger
- 35', 35", 35'": Substratadapter
- 40, 40', 40", 40'": Schutzfolie

## Patentansprüche

1. Verfahren zum Herstellen mindestens eines vereinzelten Halbleiterelements (10', 10", 10"') mit einem Substratadapter (35', 35", 35'"), umfassend die Schritte:
- Strukturieren eines elektrisch leitenden Metallelements (12),
- Aufbringen eines ersten Kontaktierungsmaterials (11) auf eine erste Seite (13) eines Halbleiterelements (10), wobei das Halbleiterelement (10) mit einer zweiten Seite (14) auf einem Transportelement (20) angeordnet ist,
- Positionieren des strukturierten Metallelements (12) und des Halbleiterelements (10) derart, dass eine erste Seite (21) des strukturierten Metallelements (12) und die mit dem ersten Kontaktierungsmaterial (11) versehene erste Seite (13) des Halbleiterelements (10) gegenüber angeordnet sind, und
- Fügen des strukturierten Metallelements (12) mit dem mit erstem Kontaktierungsmaterial (11) versehenen Halbleiterelement (10),
- Vereinzeln des Halbleiterelements (10) und des mit dem Halbleiterelement (10) und dem Kontaktierungsmaterial (11) zusammengefügten strukturierten Metallelements (12) zur weiteren Verarbeitung derart, dass das Transportelement (20) die durch die vereinzelten Metallelemente (12', 12", 12") und dem ersten Kontaktierungsmaterial (11) gebildeten Substratadapter (35', 35", 35'") in einem Abstand zueinander fixiert,
- wobei zumindest ein vereinzeltes Halbleiterelement (10', 10", 10"') mit dem darauf befindlichen Substratadapter (35', 35", 35'") vom Transportelement (20) entfernt und auf einen mit einem zweiten Kontaktierungsmaterial (25) versehenen Träger (30) aufgebracht wird, wobei die zweite Seite (14) des vereinzelten Halbleiterelements (10', 10", 10"') mit dem mit dem zweiten Kontaktierungsmaterial (25) versehenen Träger (30) in Kontakt gebracht wird,
wobei das vereinzelte Halbleiterelement (10', 10", 10"') anschließend vom Träger (30) abgelöst wird und das zweite Kontaktierungsmaterial (25) dabei am vereinzelten Halbleiterelement (10', 10", 10"') haften bleibt, wobei das Transportelement (20) und der Träger (30) eine Folie ist,
wobei eine Adhäsion zwischen dem Transportelement (20) und dem vereinzelten Halbleiterelement (10', 10", 10"') geringer ist als die Adhäsion einer Verbindung zwischen dem vereinzelten Halbleiterelement (10', 10", 10"') und dem ersten Kontaktierungsmaterial (11) und zwischen dem ersten Kontaktierungsmaterial (11) und dem vereinzelten Metallelement (12', 12", 12"') wobei
weiterhin eine Adhäsion zwischen dem Träger (30) und dem zweiten Kontaktierungsmaterial (25) geringer ist als die Adhäsion einer Verbindung zwischen dem vereinzelten Halbleiterelement (10', 10", 10"') und dem zweiten Kontaktierungsmaterial (25), und einer Verbindung zwischen dem ersten Kontaktierungsmaterial (11) und dem vereinzelten Metallelement (12', 12", 12"').

2. Verfahren nach Anspruch 1, **dadurch gekennzeichnet, dass**
das Transportelement (20) ein Film-Frame ist.

3. Verfahren nach einem der vorhergehenden Ansprüche, **gekennzeichnet durch**
Aufbringen einer Schutzfolie (40) auf die zweite Seite (22) des strukturierten Metallelements (12), vorzugsweise vor dem Vereinzeln des mit dem Halbleiterelement (10) und dem Kontaktierungsmaterial (11) zusammengefügten strukturierten Metallelements (12).

4. Verfahren nach einem der vorhergehenden Ansprüche,
**dadurch gekennzeichnet, dass**
das Aufbringen des Kontaktierungsmaterials (11) auf die erste Seite (13) des Halbleiterelements (10) und/oder das Aufbringen des weiteren Kontaktierungsmaterials (25) auf eine Seite (31) des Trägers (30) mit einer vorbestimmten Struktur ausgeführt wird, die passgenau zur Struktur des strukturierten Metallelements (12) und/oder zur Struktur des Halbleiterelements (10), ist.

5. Verfahren nach einem der vorhergehenden Ansprüche,
**dadurch gekennzeichnet, dass**
während des Fügens des Metallelements (12) mit dem Halbleiterelement (10) auf die zweite Seite (22) des Metallelements (12) ein Stempel wirkt, bei einer Temperatur von 60 °C - 130 °C, insbesondere von 70 °C - 110 °C, insbesondere von 80 °C - 100 °C.

6. Verfahren nach Anspruch 5,
**dadurch gekennzeichnet, dass**
während des Fügens auf die zweite Seite (14) des Halbleiterelements (10) und/oder auf das Transportmittel (20) und/oder auf den Träger (30) ein Gegenhalter und/oder ein Gegenstempel wirkt.

7. Verfahren nach einem der vorhergehenden Ansprüche, insbesondere nach einem der Ansprüche 3 bis 6, **dadurch gekennzeichnet, dass**
das mit dem Halbleiterelement (10) zusammengefügte, strukturierte, und optional mit einer/der Schutzfolie (40) versehene Metallelement (12), vorzugsweise durch Sägen oder Laserschneiden oder Stanzen oder Ätzen oder Wasserstrahlschneiden, vereinzelt wird.

## Claims

1. Method of producing at least one singulated semiconductor element (10', 10", 10"') with a substrate adapter (35', 35", 35"') comprising the steps:
- structuring of an electrically conductive metal element (12),
- application of a first contacting material (11) on a first side (13) of a semiconductor element (10), wherein the semiconductor element (10) is arranged with a second side (14) on a transport element (20),
- positioning of the structured metal element (12) and the semiconductor element (10) in such a way that a first side (21) of the structured metal element (12) and the first side (13) of the semiconductor element (10) provided with the first contacting material (11) are arranged opposite each other, and
- joining of the structured metal element (12) with the semiconductor element (10) provided with the first contacting material (11),
- singulation of the semiconductor element (10) and the structured metal element (12) joined together with the semiconductor element (10) and the contacting material (11) for further processing in such a way that the transport element (20) fixes the substrate adapter (35', 35", 35"') formed by the singulated metal elements (12', 12", 12"') and the first contacting material (11) at a distance from one another,
- wherein at least one singulated semiconductor element (10', 10", 10"'), with the substrate adapter (35', 35", 35"') located on it, is removed from the transport element (20) and mounted on a support (30) provided with a second contacting material (25), wherein the second side (14) of the singulated semiconductor element (10', 10", 10"') is brought into contact with the support (30) provided with the second contacting material (25),
wherein the singulated semiconductor element (10', 10", 10"') is then detached from the support (30) and the second contacting material (25) remains adhered to the singulated semiconductor element (10', 10", 10"'),
wherein the transport element (20) and the carrier (30) is a foil,
wherein the adhesion between the transport element (20) and the singulated semiconductor element (10', 10", 10"') is less than the adhesion of a connection between the singulated semiconductor element (10', 10", 10"') and the first contacting material (11) and between the first contacting material (11) and the singulated metal element (12', 12", 12"'),
wherein further, the adhesion between the support (30) and the second contacting material (25) is less that the adhesion of a connection between the singulated semiconductor element (10', 10", 10"') and the second contacting material (25) and a connection between the first contacting material (11) and the singulated metal element (12', 12", 12"').

2. Method according to claim 1 **characterised in that** the transport element (20) is a film frame.

3. Method according to any one of the preceding claims
**characterised by**
application of a protective foil (40) on the second side (22) of the structured metal element (12), preferably before the singulation of the structured metal element (12) joined together with the semiconductor element (10) and the contacting material (11) .

4. Method according to any one of the preceding claims
**characterised in that**
the application of the contacting material (11) onto the first side (13) of the semiconductor element (10) and/or the application of the further contacting material (25) to a side (31) of the support (30) is carried out with a predetermined structure which precisely fits the structure of the structured metal element (12) and/or the structure of the semiconductor element (10).

5. Method according to any one of the preceding claims
**characterised in that**
during joining of the metal element (12) with the semiconductor element (10) a stamp acts on the second side (22) of the metal element (12) at a temperature of 60°C - 130°C, in particular 70°C - 110°C, more particularly 80°C - 100°C.

6. Method according to claim 5
**characterised in that**
during the joining a counter support and/or counterstamp acts on the second side (14) of the semiconductor element (10) and/or on the transport element (20) and/or on the support (30).

7. Method according to any one of the preceding claims, in particular according to any one of claims 3 to 6
**characterised in that**
the structured metal element (12) joined together with the semiconductor element (10) and optionally provided with a/the protective foil (40) is singulated, preferably by means of sawing or laser cutting, or punching or etching or water jet cutting.

## Revendications

1. Procédé de fabrication d'au moins un élément semi-conducteur isolé (10', 10", 10"') avec un adaptateur de substrat (35', 35", 35""), comprenant les étapes suivantes :
- structuration d'un élément métallique électroconducteur (12),
- application d'un premier matériau de contact (11) sur un premier côté (13) d'un élément semi-conducteur (10), sachant que l'élément semi-conducteur (10) avec un deuxième côté (14) est disposé sur un élément de transport (20),
- positionnement de l'élément métallique structuré (12) et de l'élément semi-conducteur (10) de telle manière qu'un premier côté (21) de l'élément métallique structuré (12) et le premier côté (13) de l'élément semi-conducteur (10) doté du premier matériau de contact (11) sont disposés l'un en face de l'autre, et
- assemblage de l'élément métallique structuré (12) avec l'élément semi-conducteur (10) doté du premier matériau de contact (11),
- séparation de l'élément semi-conducteur (10) et de l'élément métallique structuré (12) assemblé à l'élément semi-conducteur (10) et au matériau de contact (11) pour traitement ultérieur de telle manière que l'élément de transport (20) fixe l'un par rapport à l'autre à une distance les adaptateurs de substrat (35', 35", 35"') formés par les éléments métalliques isolés (12', 12", 12"') et le premier matériau de contact (11),
- sachant qu'au moins un élément semi-conducteur isolé (10', 10",10"') avec l'adaptateur de substrat (35', 35", 35"') se trouvant dessus est éloigné de l'élément de transport (20) et est appliqué sur un support (30) doté d'un deuxième matériau de contact (25), sachant que le deuxième côté (14) de l'élément semi-conducteur isolé (10', 10", 10"') est mis en contact avec le support (30) doté du deuxième matériau de contact (25),
- sachant que l'élément semi-conducteur isolé (10', 10", 10"') est séparé ensuite du support (30) et que le deuxième matériau de contact (25) reste adhéré à l'élément semi-conducteur isolé (10', 10", 10"'),
sachant que l'élément de transport (20) et le support (30) sont représentés par un film,
sachant qu'une adhérence entre l'élément de transport (20) et l'élément semi-conducteur isolé (10', 10", 10'") est plus faible que l'adhérence d'une liaison entre l'élément semi-conducteur isolé (10', 10", 10'") et le premier matériau de contact (11) et entre le premier matériau de contact (11) et l'élément métallique isolé (12', 12", 12"'),
sachant en outre qu'une adhérence entre le support (30) et le deuxième matériau de contact (25) est plus faible que l'adhérence d'une liaison entre l'élément semi-conducteur isolé (10', 10", 10'") et le deuxième matériau de contact (25) et une liaison entre le premier matériau de contact (11) et l'élément métallique isolé (12', 12", 12"').

2. Procédé selon la revendication 1, **caractérisé en ce que** l'élément de transport (20) est un cadre de film.

3. Procédé selon l'une quelconque des revendications précédentes,
**caractérisé par**
l'application d'un film protecteur (40) sur le deuxième côté (22) de l'élément métallique structuré (12), de préférence avant la séparation de l'élément métallique structuré (12) assemblé à l'élément semi-conducteur (10) et au matériau de contact (11).

4. Procédé selon l'une quelconque des revendications précédentes,
**caractérisé en ce que**
l'application du matériau de contact (11) sur le premier côté (13) de l'élément semi-conducteur (10) et/ou l'application de l'autre matériau de contact (25) sur un côté (31) du support (30) est exécutée avec une structure prédéterminée, qui est exactement ajustée à la structure de l'élément métallique structuré (12) et/ou à la structure de l'élément semi-conducteur (10).

5. Procédé selon l'une quelconque des revendications précédentes,
**caractérisé en ce que**
pendant l'assemblage de l'élément métallique (12) avec l'élément semi-conducteur (10) un tampon agit sur le deuxième côté (22) de l'élément métallique (12), à une température de 60° C - 130° C, en particulier de 70° C - 110° C, en particulier de 80° C - 100° C.

6. Procédé selon la revendication 5,
**caractérisé en ce que**
pendant l'assemblage un contre-support et/ou un contre-tampon agit sur le deuxième côté (14) de l'élément semi-conducteur (10) et/ou sur le moyen de transport (20) et/ou sur le support (30).

7. Procédé selon l'une quelconque des revendications précédentes, en particulier selon l'une quelconque des revendications 3 à 6,
**caractérisé en ce que**
l'élément métallique (12) structuré, assemblé à l'élément semi-conducteur (10) et doté en option d'un/du film protecteur (40) est séparé de préférence par sciage ou découpe au laser ou estampage ou attaque caustique ou découpe au jet d'eau.
